# EUROPEAN PATENT APPLICATION

(11) **EP 4 084 062 A1**
(43) Date of publication of application: **02.11.2022**
(21) Application number: 21171512.3
(22) Date of filing: 30.04.2021
(51) Int. Cl.: H01L 23/49, H01L 23/367, H01L 25/07, H01L 23/24

(54) **POWER SEMICONDUCTOR MODULE ARRANGEMENT**

(71) Applicant: Infineon Technologies AG, 85579 Neubiberg (DE)
(72) Inventor: HARTUNG, Hans, 59581 Warstein (DE); BROLL, Marian Sebastian, 59494 Soest (DE); EHLERS, Carsten, 41066 Mönchengladbach (DE); SAUERLAND, Frank, 59368 Werne (DE)
(74) Representative: Westphal, Mussgnug & Partner, Patentanwälte mbB

(57) **Abstract**

A power semiconductor module arrangement (100) comprises a housing (7), a substrate (10) arranged inside the housing (7), the substrate (10) comprising a dielectric insulation layer (11), a plurality of components arranged inside the housing (7), at least one bonding wire or ribbon (3) arranged inside the housing (7) and providing an electrical connection between a first component of the plurality of components and a second component of the plurality of components, and a casting compound (5) arranged inside the housing (7), wherein at least one of the at least one bonding wire or ribbon (3) is covered by an insulating layer (32), and the casting compound (5) covers the substrate (10), and at least partly covers the at least one bonding wire or ribbon (3).

## Description

### TECHNICAL FIELD

The instant disclosure relates to a power semiconductor module arrangement.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted to the semiconductor substrate by soldering or sintering techniques. Electrical connections inside the housing are often implemented by means of, e.g., bonding wires or bonding ribbons. The material of such wire bonds or ribbons can heat during the use of the power semiconductor module arrangement. This may lead to unwanted degradation effects negatively affecting the material of the wire bonds or ribbons. This can significantly reduce the lifetime of the power semiconductor module arrangement.

There is a need for a power semiconductor module arrangement which is less prone to degradation effects and has an increased lifetime.

### SUMMARY

A power semiconductor module arrangement includes a housing, a substrate arranged inside the housing, the substrate comprising a dielectric insulation layer, a plurality of components arranged inside the housing, at least one bonding wire or ribbon arranged inside the housing and providing an electrical connection between a first component of the plurality of components and a second component of the plurality of components, and a casting compound arranged inside the housing, wherein at least one of the at least one bonding wire or ribbon is covered by an insulating layer, and the casting compound covers the substrate, and at least partly covers the at least one bonding wire or ribbon.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of a power semiconductor module arrangement according to one example.
Figure 3, including Figures 3A and 3B, schematically illustrates cross-sectional views of a bonding wire and a bonding ribbon.
Figure 4 schematically illustrates another cross-sectional view of a bonding wire or ribbon.
Figure 5 is a cross-sectional view of a power semiconductor module arrangement according to another example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

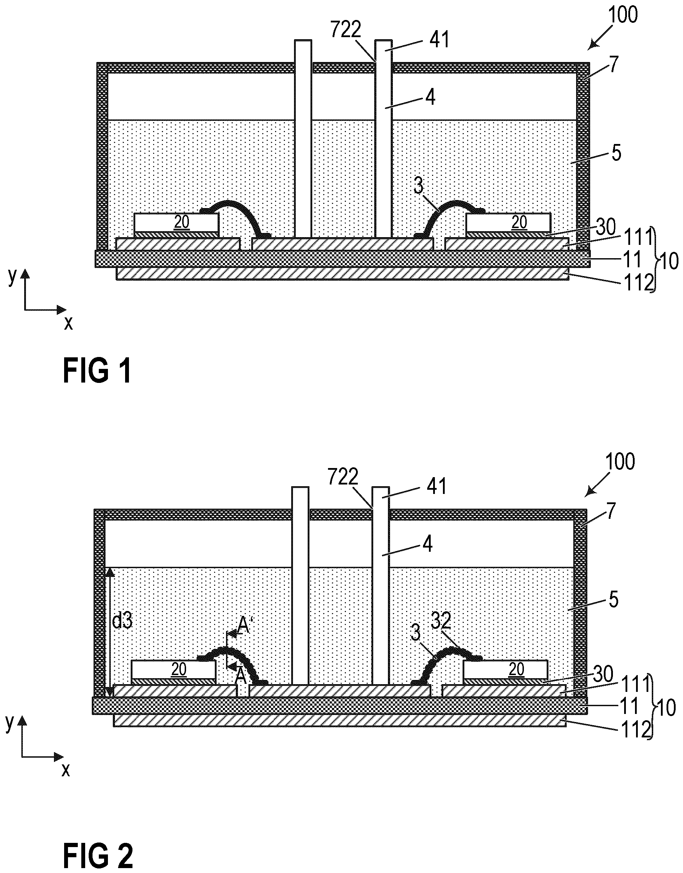

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112. The second metallization layer 112, however, is optional and can be omitted.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a ground surface of the housing 7, while the housing 7 itself solely comprises sidewalls and a cover. This is, however, only an example. It is also possible that the housing 7 further comprises a ground surface and the substrate 10 be arranged inside the housing 7. According to another example, the substrate 10 may be mounted on a base plate (not illustrated). In some power semiconductor module arrangements 100, more than one substrate 10 is arranged on a single base plate. The base plate may form a ground surface of the housing 7 and may be mounted on a heat sink (not illustrated), for example.

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include bonding ribbons, connection plates or conductor rails, for example, to name just a few examples. The one or more semiconductor bodies 20 may be electrically and mechanically connected to the substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes through an opening 722 and out of the housing 7. The terminal elements 4 may be electrically contacted from the outside at their second end 41. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 can also extend vertically or horizontally through the sidewalls of the housing 7, for example. Any other suitable implementation is possible.

Conventional power semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 41, however, are not covered by the casting compound 5 and protrude from the casting compound 5 through the housing 7 to the outside of the housing 7. The casting compound 5 is configured to protect the components and electrical connections inside the power semiconductor module 100, in particular inside the housing 7, from certain environmental conditions and mechanical damage. The casting compound 5 further provides for an electrical isolation of the components inside the housing 7.

Electrical connections 3 such as wire bonds or wire ribbons can be used to electrically couple a first component (e.g., semiconductor body 20, first metallization layer 111, terminal element 4) arranged inside the housing 7 to a second component (e.g., semiconductor body 20, first metallization layer 111, terminal element 4) arranged inside the housing 7. As has been explained above, semiconductor bodies 20 can be electrically coupled to the first metallization layer 11 by means of wire bonds or ribbons. A first section of the first metallization layer 111 can be electrically coupled to one or more other sections of the first metallization layer 111 by means of bonding wires or ribbons. Bonding wires or ribbons can also be used, e.g., to electrically couple different semiconductor bodies 20 to each other, to electrically couple a semiconductor body 20 to a terminal element 4, to electrically couple a terminal element 4 to another terminal element 4, or to electrically couple a terminal element 4 to the first metallization layer 111. Any other components arranged inside the housing 7 can be electrically coupled by means of bonding wires or ribbons 3.

Bonding wires or ribbons 3 can comprise an electrically conducting material such as, e.g., aluminum, copper, a metal alloy or a noble metal. According to one example, a bonding wire comprises a core of a first metal or metal alloy that is covered by a layer of another metal or metal alloy. For example, a bonding wire may comprise a copper or copper alloy core that is covered by a layer of aluminum or aluminum alloy. During the use of the power semiconductor module arrangement 100, the bonding wires or ribbons 3 are generally heated to a certain degree. This may lead to unwanted degradation effects of the material of the bonding wires or ribbons 3. If the (heated) material of the bonding wires or ribbons 3 comes into contact with air, this can also lead to further unwanted degradation effects. In this way, the lifetime of the power semiconductor module arrangement 100 can be significantly reduced. Therefore, the bonding wires or ribbons 3 are generally covered by the casting compound 5, as has been described above and as is illustrated in Figure 1. However, when forming a thick casting compound 5 covering the substrate 10 and the components mounted thereon, unwanted bubbles or voids may form in the casting compound 5 which can negatively affect the operation of the power semiconductor module arrangement.

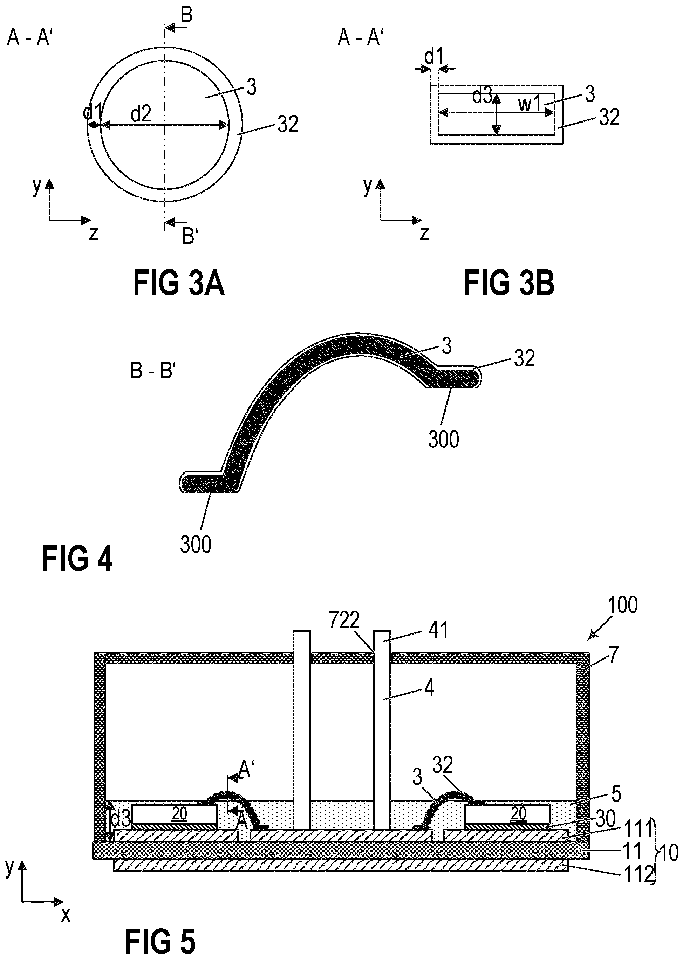

Now referring to Figure 2, a power semiconductor module arrangement 100 according to one example is schematically illustrated. The power semiconductor module arrangement 100 of Figure 2 essentially corresponds to the power semiconductor module arrangement of Figure 1. However, in the power semiconductor module arrangement 100 illustrated in Figure 2, the bonding wires or ribbons 3 are covered by an insulating layer 32. This is schematically illustrated in the cross-sectional views along a section plane A - A' in Figure 3A for a bonding wire and in Figure 3B for a bonding ribbon. Figure 4 schematically illustrates a cross-sectional view of a bonding ribbon along a section plane B - B'. As can be seen, the bonding wire or ribbon 3 is completely covered by the insulating layer 32, except for the connecting surfaces 300 which are in direct contact with one of the elements (e.g., semiconductor bodies 20, first metallization layer 111, terminal element 4) of the power semiconductor module arrangement 100. The connecting surfaces 300 remain free of the insulating layer 300 in order to be able to form a permanent mechanical and electrical connection (e.g., solder connection) between the bonding wire or ribbon 3 and the respective element of the power semiconductor module arrangement 100.

The insulating layer 32 comprises an electrically insulating material. For example, the insulating layer 32 may comprise an inorganic material such as, e.g., a polymer or polyimide. The insulating layer 32 can be formed, for example, by means of an atomic layer deposition (ALD) technique. The insulating layer 32 may have a thickness d1 of, e.g., 5 micrometer (µm) or more. If an ALD technique is used for forming the insulating layer 32, for example, the thickness d1 may be even less such as, e.g., 1µm or more. The thickness d1 of the insulating layer 32, however, may be less than a maximum dimension (e.g., diameter or width) of the bonding wire or ribbon 3. According to one example, a maximum thickness d1 of the insulating layer 32 is 10µm. A bonding wire generally has a round cross-section. A diameter d2 of such a bonding wire can be between 50 and 600µm, for example. A bonding ribbon generally has a rectangular cross-section. That is, a width w1 of the bonding ribbon is generally larger than its thickness d3. A bonding ribbon, e.g., may have a width w1 of at least 500µm, at least 700µm, at least 1000µm, or at least 2000µm, and at most 3000µm, for example. The bonding ribbon may have a thickness d3 of at least 50µm, at least 100µm, or at least 150µm, and at most 400µm, for example. A bonding wire or ribbon 3 can also have other cross-sections than round or rectangular such as oval or square, for example.

A connection between the bonding wire or ribbon 3 and the respective component of the power semiconductor module arrangement 100 can be formed by means of a bonding process. Several different methods for establishing a permanent electrical connection or bond between a bonding wire or ribbon 3 and an electrically conductive surface are known. Such known methods include the so-called wedge bonding, or wedge/wedge bonding. Wedge bonding processes usually utilize ultrasonic energy and pressure to create a bond between the bonding wire and the bond pad. Wedge bonding processes are generally low temperature processes which are performed at room temperature. This, however, is only an example. Any other processes can be used to form the desired connection.

The insulating layer 32 protects the bonding wires or ribbons, e.g., against so-called flash-over effects. Flash-over effects may occur between different bonding wires or ribbons 3 that are arranged close to each other and that are connected to different electrical potentials. Therefore, the casting compound 5 is not necessarily needed anymore to prevent flash-over effects. As is schematically illustrated in Figure 5, the thickness d4 of the casting compound in a vertical direction y can be reduced if the bonding wires or ribbons 3 are covered by the insulating layer 32. The casting compound 5 may still cover the substrate 10 and the semiconductor bodies 20 mounted thereon. However, the bonding wires or ribbons 3 can only be partly covered by the casting compound 5. Some sections of the bonding wires or ribbons 3 can protrude from the casting compound 5. A casting compound 5 having a reduced thickness d4 can have several advantages as compared to casting compounds 5 having a large thickness d4 (see, e.g., Figure 2). For example, the power cycling capability can be increased if the thickness d4 of the casting compound is reduced. Further, the risk of formation of unwanted voids or bubbles in the casting compound 5 can be reduced.

## Claims

1. A power semiconductor module arrangement (100) comprises:
a housing (7);
a substrate (10) arranged inside the housing (7), the substrate (10) comprising a dielectric insulation layer (11);
a plurality of components arranged inside the housing (7);
at least one bonding wire or ribbon (3) arranged inside the housing (7) and providing an electrical connection between a first component of the plurality of components and a second component of the plurality of components; and
a casting compound (5) arranged inside the housing (7), wherein
at least one of the at least one bonding wire or ribbon (3) is covered by an insulating layer (32), and
the casting compound (5) covers the substrate (10), and at least partly covers the at least one bonding wire or ribbon (3).

2. The power semiconductor module arrangement (100) of claim 1, wherein the plurality of components comprises at least one of a semiconductor body (20), a terminal element (4), and a section of a first metallization layer (111) attached to the dielectric insulation layer (11).

3. The power semiconductor module arrangement (100) of claim 1 or 2, wherein the insulating layer (32) comprises an inorganic material.

4. The power semiconductor module arrangement (100) of any of claims 1 to 3, wherein the insulating layer (32) comprises a polymer or polyimide.

5. The power semiconductor module arrangement (100) of any of the preceding claims, wherein the insulating layer (32) has a thickness (d1) of at least 1µm, or at least 5µm.

6. The power semiconductor module arrangement (100) of any of the preceding claims, wherein a thickness (d1) of the insulating layer (32) is less than a maximum dimension of the bonding wire or ribbon (3).

7. The power semiconductor module arrangement (100) of claim 6, wherein the thickness (d1) of the insulating layer (32) is less than 10µm.

8. The power semiconductor module arrangement (100) of any of the preceding claims, wherein at least one of the at least one bonding wire or ribbon (3) has a round cross-section with a diameter (d2) of between 50 and 600µm.

9. The power semiconductor module arrangement (100) of any of claims 1 to 7, wherein at least one of the at least one bonding wire or ribbon (3) has a rectangular cross-section having a width (w1) of at least 500µm, at least 700µm, at least 1000µm, or at least 2000µm, and at most 3000µm, and having a thickness (d3) of at least 50µm, at least 100µm, or at least 150µm, and at most 400µm.

10. The power semiconductor module arrangement (100) of any of the preceding claims, wherein the at least one bonding ribbon or wire (3) is completely covered by the insulating layer (32) except for any connecting surfaces (300) of the bonding wire or ribbon (3) which are in direct contact with one of the components of the power semiconductor module arrangement (100).

11. The power semiconductor module arrangement (100) of any of the preceding claims, wherein
each of the at least one bonding ribbon or wire (3) is completely covered by the insulating layer (32) except for any connecting surfaces (300) of the bonding wire or ribbon (3) which are in direct contact with one of the components of the power semiconductor module arrangement (100); and
the at least one bonding wire or ribbon (3) is only partly covered by the casting compound (5).

12. The power semiconductor module arrangement (100) of any of the preceding claims, wherein each of the at least one bonding wire or ribbon (3) comprises at least one of copper or aluminum.

13. The power semiconductor module arrangement (100) of any of the preceding claims, wherein each of the at least one bonding wire or ribbon (3) comprises a core of a first metal or metal alloy that is covered by a layer of another metal or metal alloy.
